# EUROPÄISCHE PATENTANMELDUNG

(11) **EP 3 404 675 A1**
(43) Veröffentlichungstag der Anmeldung: **21.11.2018**
(21) Anmeldenummer: 17171188.0
(22) Anmeldetag: 15.05.2017
(51) Int. Cl.: H01C 1/144, H05K 1/16, H05K 3/40, H01C 7/00

(54) **LEISTUNGSWIDERSTAND**

(71) Anmelder: EBG Elektronische Bauelemente GmbH, 4663 Laakirchen (AT)
(72) Erfinder: Lindner, Christian Rene, 8341 Paldau (AT); Praschk, Josef, 8082 Kirchbach in der Steiermark (AT)
(74) Vertreter: Jell, Friedrich

(57) **Zusammenfassung**

Es wird ein Leistungswiderstand (1) mit mindestens einem elektrischen Anschluss (2.1, 2.2, 2.3), mit einem Trägersubstrat (3), das mindestens ein Widerstandselement (4.1, 4.2) aus einem Dickschichtmaterial und mindestens eine Kontaktelektrode (5.1, 5.2, 5.3) aufweist, an die das Widerstandselement (4.1, 4.2) elektrisch anschließt, mit wenigstens einem elektrischen Leiter (7.1, 7.2, 7.3), der mit der Kontaktelektrode (5.1, 5.2, 5.3) verlötet ist und eine elektrische Verbindung zwischen der Kontaktelektrode (5.1, 5.2, 5.3) und dem elektrischen Anschluss (2.1, 2.2, 2.3) herstellt, und mit einem, zumindest teilweise mit mindestens einer Vergussmasse (17) gefüllten Gehäuse (8), das Widerstandselement (4.1, 4.2) und Kontaktelektrode (5.1, 5.2, 5.3) vergossen aufnimmt, wobei der elektrische Leiter (7.1, 7.2, 7.3) durch die Vergussmasse (17) ragt. Um einen konstruktiv einfachen und leicht handhabbaren Leistungswiderstand (1) zu schaffen, wird vorgeschlagen, dass ein Stift, insbesondere ein Löt- oder Einpressstift, den elektrischen Leiter (7.1, 7.2, 7.3) ausbildet, welcher Stift (9.1, 9.2, 9.3) auf die Kontaktelektrode (5.1, 5.2, 5.3) aufgesetzt und mit dieser verlötet ist sowie den elektrischen Anschluss (2.1, 2.2, 2.3) des Leistungswiderstands (1) ausbildet.

## Beschreibung

Die Erfindung betrifft einen Leistungswiderstand mit mindestens einem elektrischen Anschluss, mit einem Trägersubstrat, das mindestens ein Widerstandselement aus einem Dickschichtmaterial und mindestens eine Kontaktelektrode aufweist, an die das Widerstandselement elektrisch anschließt, mit wenigstens einem elektrischen Leiter, der mit der Kontaktelektrode verlötet ist und eine elektrische Verbindung zwischen der Kontaktelektrode und dem elektrischen Anschluss herstellt, und mit einem, zumindest teilweise mit mindestens einer Vergussmasse gefüllten Gehäuse, das Widerstandselement und Kontaktelektrode vergossen aufnimmt, wobei der elektrische Leiter durch die Vergussmasse ragt.

Um zwischen den Anschlüssen eines Leistungswiderstands und dem Widerstandselement auf einem keramischen Trägersubstrat im vergossenen Gehäuse des Hochleistungswiderstands eine elektrische Verbindung herzustellen, ist es bekannt (DE3715860A1), flexible elektrische Leiter vorzusehen. Diese Leiter sind je einerends mit einer Elektrode des Schichtwiderstands verlötet und anderends an einen elektrischen Anschluss befestigt, welcher in der Art eines Kabelschuhs ausgeführt ist. Nachteilig bedarf es für eine derartige elektrische Verbindung eines vergleichsweise hohen Herstellungsaufwands.
Zudem bedürfen derart ausgeführte Steck-Anschlüsse einer standfesten mechanischen Anbindung an das Gehäuse bzw. damit aufwendiger mechanischer Sicherungsmaßnahmen, um sowohl Montagekräften beim elektrischen Anschluss des Leistungswiderstands als auch einer Wärmedehnung standzuhalten, den elektrischen Kontakt mit dem elektrischen Leiter sicherzustellen.

Die Erfindung hat sich daher die Aufgabe gestellt, einen Leistungswiderstand der eingangs geschilderten Art derart zu verändern, dass bei konstruktiver Einfachheit erhöhte Standfestigkeit am Leistungswiderstand erreichbar ist.

Die Erfindung löst die gestellte Aufgabe dadurch, dass ein Stift, insbesondere ein Löt- oder Einpressstift, den elektrischen Leiter ausbildet, welcher Stift auf die Kontaktelektrode aufgesetzt und mit dieser verlötet ist sowie den elektrischen Anschluss des Leistungswiderstands ausbildet.

Eine deutliche konstruktive Vereinfachung in der elektrischen Verbindung der Elektrode auf dem Trägersubstrat mit dem Anschluss am Leistungswiderstand kann sich ergeben, wenn ein Stift, insbesondere ein Löt- oder Einpressstift, den elektrischen Leiter ausbildet, welcher Stift auf die Kontaktelektrode aufgesetzt und mit dieser verlötet ist sowie den elektrischen Anschluss des Leistungswiderstands ausbildet. Erfindungsgemäß dient damit der elektrische Leiter auch als elektrischer Anschluss am Leistungswiderstand - womit sich zur elektrischen Verbindung zwischen Elektrode und Anschluss eine aus dem Stand der Technik bekannte, feste elektrische Kontaktstelle zwischen Leiter und Anschluss erübrigt. Dies kann die Gefahr eines Leitungsbruchs an vorgenannter Kontaktstelle ausschließen - und so zur Erhöhung der Standfestigkeit am Leistungswiderstand beitragen, zumal auch Wärmedehnungseffekte vom Stift aufgenommen und vom Leistungswiderstand abgetragen werden können.
Jene auf den Anschluss wirkenden mechanischen Belastungen können in weiterer Folge durch die auf der Elektrode aufgesetzten Verlötung des Stifts ohne Weiteres vom Trägersubstrat aufgenommen und damit abgetragen werden, ohne dass mit einem Leitungsbruch in der elektrischen Verbindung zwischen Kontaktelektrode und Anschluss gerechnet werden muss. Außerdem kann die Vergussmasse, durch die der Stift ragt, zur mechanischen Stabilität des Anschlusses zusätzlich beitragen. Die konstruktive Vereinfachung des Leistungswiderstands durch Zuhilfenahme eines Stifts kann daher auch die Standfestigkeit am Leistungswiderstand weiter erhöhen. Ein standfester, einfach handzuhabender und anschlusssicherer Leistungswiderstand kann sohin geschaffen werden.
Letzteres kann weiter verbessert werden, wenn der Stift als Einpressstift ausgebildet ist und damit am Anschluss des Widerstandelements eine elektrische Verbindung mit Kraftschluss herstellbar ist.

Weist der Stift an seinem ersten Ende eine ebene Stirnfläche auf, welche auf der Kontaktelektrode aufgesetzt und mit dieser verlötet ist, kann der feste elektrische Kontakt hinsichtlich seiner elektrischen und mechanischen Eigenschaften weiter verbessert werden. Damit können unter anderem Kerbwirkungen zwischen Einpressstift und Elektrode sowohl beim stoffschlüssigen Verlöten als auch bei mechanischen Belastungen vermieden werden, was die Gefahr einer punktuellen Schwächung des festen elektrischen Kontakts vermindert.

Der elektrische und mechanische Kontakt zwischen Elektrode und Einpressstift kann vergrößert werden, wenn der Einpressstift an seinem ersten Ende einen auskragenden Montagekopf aufweist. Dieser Montagekopf kann in Form eines Fußes, was beispielsweise zu eine L-förmigen Einpressstift führt, oder umlaufend auskragend, was beispielsweise zu eine T-förmigen Einpressstift führt, ausgebildet sein.

Kragt der Montagekopf umlaufend aus, können etwa mechanische Belastungen richtungsunabhängig gleichmäßiger auf das Trägersubstrat abgetragen werden. Derart ist auch die Standfestigkeit des Leistungswiderstands weiter verbesserbar. Letzteres besonders dadurch, wenn der Montagekopf kreisrund umlaufend auskragt und damit mechanische Belastungen richtungsunabhängig aufgenommen werden können.

Alternativ zu einer umlaufenden Auskragung kann der Montagekopf mindestens einen Lötfuß aufweisen, damit er auf einer vergleichsweise schmalen Kontaktelektroden vorgesehbar ist. Weist der Stift zwei Lötfüße auf, kann dies von einer L-förmigen Ausbildung zu einer T-förmigen Ausbildung am Stift führen.

Konstruktiv einfach gelöst, kann die Kontaktfläche vergrößert werden, indem der auskragende Montagekopf die ebene Stirnfläche ausbildet.

Vorzugsweise sind auf dem Trägersubstrat mehrere Kontaktelektroden mit je mindestens einem angelöteten Stift vorgesehen sind, wobei an zwei Kontaktelektroden je ein Widerstandselement elektrisch anschließt. Damit werden für beide Anschlüsse des Widerstandselements dieselben erfindungsgemäßen Vorteile nutzbar.

Bildet der als Einpressstift ausgeführte Stift mit seinem Einpresskopf den elektrischen Anschluss aus, kann eine sichere Anschlussmöglichkeit am Leistungswiderstand geschaffen werden - welche außerdem die Montage des Leistungswiderstands erleichtern kann.

Steht der Einpresskopf dem Gehäuse vor, kann sich aufgrund des gegenüber dem Gehäuse frei zugänglichen elektrischen Anschlusses die Montage des Widerstandselements weiter erleichtern.

Vorzugsweise weist das Gehäuse eine offene Breitseite auf, um dieses als Gussform für die Vergussmasse nutzbar zu machen. Die Herstellung des Widerstandselements kann damit erleichtert und in seinen Kosten gesenkt werden.

Die Kühlung des Widerstandselements und in weiterer Folge Zuverlässigkeit und Standfestigkeit können verbessert werden, wenn das Trägersubstrat an einer zweiten Breitseite des Gehäuses vorgesehen ist - insbesondere, wenn das Trägersubstrat diese Breitseite des Gehäuses ausbildet.

Die Konstruktion des Widerstandselements kann weiter vereinfacht werden, wenn es an einem plattenförmigen Trägersubstrat aus einem keramikartigen Material vorgesehen ist.

Bevorzugt kann die Vergussmasse mehrschichtig sein, wovon ein erstes Schichtmaterial auf Silikonbasis das Widerstandselement vergießt und der Stift durch ein zweites Schichtmaterial auf Epoxidharzbasis ragt, um damit mechanische Festigkeit sowie elektrische Standfestigkeit am Leistungswiderstand zu optimieren.

Die elektrische und mechanische Verbindung des Stifts mit der Kontaktelektrode kann standfester ausgeführt werden, wenn das erste Schichtmaterial auf Silikonbasis den Montagekopf des Stifts vergießt.

Im Allgemeinen wird erwähnt, dass das Widerstandselement ein Dickfilmwiderstand sein kann. Solch ein Widerstandselement kann beispielsweise durch Aufbringen von Ruthenium-basierten Widerstandspasten, Cermet, etc. auf das Trägersubstrat ausgebildet werden.
Im Allgemeinen wird weiter erwähnt, dass eine Kontaktelektrode zum elektrischen Anschluss eines Widerstandselements eine AgPd, AgPt-Dickfilmpaste, etc. aufweisen kann.
Zudem wird im Allgemeinen erwähnt, dass das elektrisch isolierende Trägersubstrat vorzugsweise plattenförmig ist. Dieses Trägersubstrat kann Keramik und/oder ein keramikartiges Material, vorzugsweise Aluminiumoxidkeramik, etc. aufweist oder daraus bestehen. Auch kann das Trägersubstrat ein Verbundwerkstoff mit einem Keramik und/oder einem keramikartigen Material sein, beispielsweise mit zwei äußeren Keramikplatten mit einer mittigen Metallplatte.

In den Figuren ist der Erfindungsgegenstand beispielsweise anhand einer Ausführungsvariante näher dargestellt. Es zeigen
- Fig. 1: eine Schnittansicht auf ein Widerstandselement,
- Fig. 2a, 2b: vergrößerte Teilansichten der Fig. 1 und

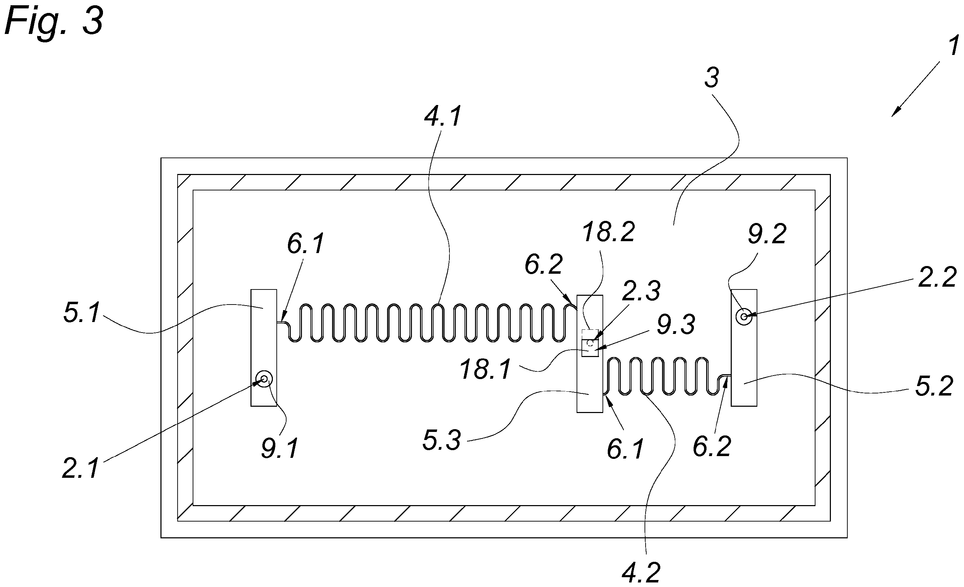

- Fig. 3: eine teilweise aufgerissene Draufsicht auf das nach Fig. 1 dargestellte Widerstandselement.

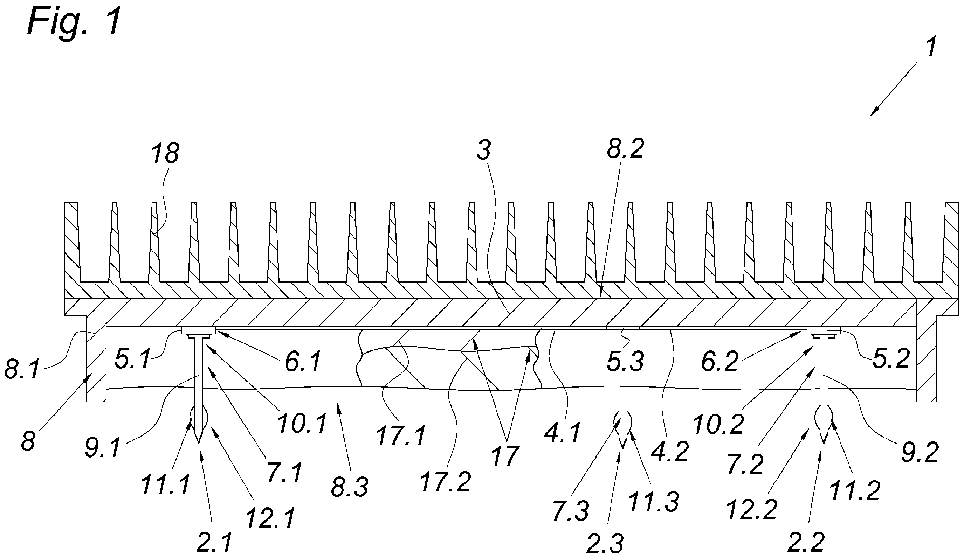

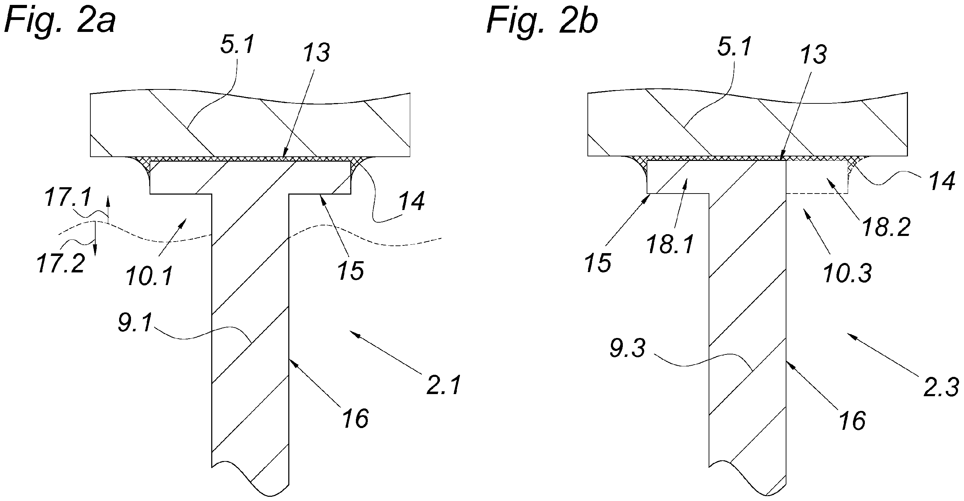

Der nach den Figuren 1, 2a und 2b beispielsweise dargestellte Leistungswiderstand 1 weist drei elektrische Anschlüsse 2.1, 2.2, 2.3 auf, welche den Hauptanschluss bzw. Leistungsanschluss des Leistungswiderstands 1 ausbilden. Im Allgemeinen ist aber auch vorstellbar, dass die elektrischen Anschlüsse 2.1, 2.2, 2.3 anderen Zwecken dienen - etwa zur Übertragung von Sensorsignalen aus dem Leistungswiderstand 1 etc., was jedoch nicht dargestellt ist.

Der Leistungswiderstand 1 weist zudem ein plattenförmiges Trägersubstrat 3 aus einem elektrisch isolierenden Material, beispielsweise keramikartigem Material, auf, was auch Aluminiumoxidkeramik sein kann. Das Trägersubstrat 3 kann ein oder mehrschichtig aufgebaut sein.

Auf dem Trägersubstrat 3 sind mehrere Widerstandselemente 4.1, 4.2 aus einem Dickschichtmaterial vorgesehen, die elektrisch in Serie geschaltet gemeinsam den Widerstand des Leistungswiderstands 1 ausbilden. Das Trägersubstrat 3 dient zudem als Wärmeleiter zur Kühlung der Widerstandselemente 4.1, 4.2.

Die beiden Widerstandselemente 4.1, 4.2 liegen elektrisch zwischen zwei Kontaktelektroden 5.1, 5.2, 5.3, die je an ein Ende 6.1 bzw. 6.2 der Widerstandselemente 4.1 bzw. 4.2 elektrisch anschließen. Zudem sind drei elektrische Leiter 7.1, 7.2, 7.3 vorgesehen, die mit der jeweiligen Kontaktelektrode 5.1, 5.2, 5.3 verlötet sind und je eine elektrische Verbindung zwischen der Kontaktelektrode 5.1 bzw. 5.2 bzw. 5.3 und den elektrischen Anschlüssen 2.1 bzw. 2.2 bzw. 2.3 herstellen.

Die Widerstandselemente 4.1, 4.2 und die Kontaktelektroden 5.1, 5.2, 5.3 werden von einem Gehäuse 8 aufgenommen und so gegenüber mechanischer Beschädigung geschützt.

Erfindungsgemäß werden die elektrischen Leiter 7.1, 7.2, 7.3 von je einem Stift 9.1, 9.2, 9.3, nämlich Einpressstift, ausgebildet. Die Stift 9.1, 9.2, 9.3 sind jeweils an ihrem ersten Ende 10.1, 10.2, 10.3 auf die jeweilige Kontaktelektrode 5.1, 5.2, 5.3 aufgesetzt und mit dieser verlötet, um einen mechanische und elektrische Verbindung auszubilden. Der Einpresskopf 11.1, 11.2, 11.3 des jeweiligen Stifts 9.1, 9.2, 9.3 am anderen zweiten Ende 11.1, 11.2, 11.3 bildet den elektrischen Anschluss 2.1, 2.2, 2.3 aus. Dadurch ist eine einfache konstruktive Lösung geschaffen, um eine standfeste elektrische Verbindung zwischen Kontaktelektrode 5.1, 5.2, 5.3 und Anschluss 2.1, 2.2, 2.3 zu ermöglichen. Es ist aber auch vorstellbar, dass der Stift 9.1, 9.2. 9.3 von einem Lötstift, also einem Stift ohne Einpresskopf, ausgebildet wird, was nicht näher dargestellt worden ist.

Wie nach Fig. 2a im Detail anhand des Stifts 9.1 zu erkennen, was beispielsweise für alle anderen Stifte 9.2 und 9.3 gilt, weisen dieser Stifts 9.1 am ersten Ende 10.1 je eine ebene Stirnfläche 13 auf. Diese ebenen Stirnflächen 13 der Stifte 9.1, 9.2, 9.3 sind auf die jeweilige Kontaktelektrode 5.1, 5.2, 5.3 aufgesetzt und mit dieser verlötet, wie dies am die Stirnfläche 13 umfassenden und überzeichnet dargestellten Lötkegel 14 erkennbar ist. Die ebenen Stirnflächen 13 befinden sich am jeweiligen Montagekopf 15 der Stifte 9.1, 9.2, 9.3.

Bei den beiden äußeren Stiften 9.1, 9.2 nach Fig. 2a kragt der Montagekopf 15 gegenüber dem Stiftbein 16 umlaufend kreisrund aus, wodurch sich die Stirnfläche 13 vergrößert. Dies führt zu einem mechanisch und elektrisch verbesserten festen Kontakt zwischen der Kontaktelektrode 5.1 bzw. 5.2 und dem jeweiligen Stift 9.1 bzw. 9.2 - womit die Standfestigkeit des Leistungswiderstands 1 erhöht wird. Ähnlich ist dies auch beim mittleren Stift 9.3 nach Fig. 2b, dessen Montagekopf 15 jedoch anders ausgebildet ist. Hier kragt ein stegförmiger Lötfüß 18.1 aus, was zu einem L-förmigen Stift 9.3 führt und so selbst bei einer schmalen Kontaktelektrode 5.3 vorgesehen werden kann. Gleiches gilt im Falle, dass zwei diametral gegenüberliegende stegförmige Lötfüße 18.1, 18.2 vorgesehen sind, wie dies in Fig. 2 strichliert zu erkennen ist, und sich damit ein T-förmiger Stift 9.3 ausbildet.

Der Aufbau des Leistungswiderstands 1 ist vergleichsweise einfach gelöst, indem das Gehäuse 8 von einer geschlossenen Seitenwand 8.1 und dem Trägersubstrat 3, als einen Abschnitt der zweiten Breitseite 8.2 gebildet wird. Damit ist am Trägersubstrat 3 ein Kühlkörper 19 vorsehbar. Unter anderem kann damit der Leistungswiderstand 1 trotz Vergussmasse 17 besonders gut gekühlt werden.

Die erste Breitseite 8.3, beispielsweise der Boden des Gehäuses 8, ist offen und gibt die Sicht auf eine Vergussmasse 17 frei, welche - in das Gehäuse 8 eingefüllt - Widerstandselement 4.1, 4.2 und Kontaktelektrode 5.1, 5.2, 5.3 verkapselt.

Nach Fig. 1 und 2a ist zu sehen, dass die Vergussmasse 17 verschiedene Materialschichten aufweisen kann, damit mehrschichtig ausgebildet sein kann. In Fig. 2a ist die Übergang zwischen den zwei Schichtmaterialien 17.1, 17.2 strichliert dargestellt. So sind das Widerstandselement 4.1, 4.2 und die Kontaktelektrode 5.1, 5.2, 5.3 im ersten Schichtmaterial 17.1 auf Silikonbasis oder aus einem Silikonwerkstoff vergossen. Auf dieses erste Schichtmaterial 17.1 ist das zweite Schichtmaterial 17.2 auf Epoxidharzbasis oder auf Polyurethanbasis oder dgl. vorgesehen. Das erste Schichtmaterial 17.1 kann das Widerstandselement 4.1, 4.2 und die Kontaktelektrode 5.1, 5.2, 5.3 elastisch verkapseln und die zweite Schicht der Festigkeit der Verkapselung erhöhen. Zudem vergießt auch das erste Schichtmaterial 17.1 auf Silikonbasis den Montagekopf 15 des Stifts 9.1, 9.2, 9.3.

Die Einpressstifte 9.1, 9.2 ragen durch diese Vergussmasse 17. Die Einpressköpfe 11.2, 11.2, 11.3 stehen dem Gehäuse 8 vor, wodurch der Leistungswiderstand 1 einfach montiert und elektrisch angeschlossen werden kann.

## Patentansprüche

1. Leistungswiderstand mit mindestens einem elektrischen Anschluss (2.1, 2.2, 2.3), mit einem Trägersubstrat (3), das mindestens ein Widerstandselement (4.1, 4.2) aus einem Dickschichtmaterial und mindestens eine Kontaktelektrode (5.1, 5.2, 5.3) aufweist, an die das Widerstandselement (4.1, 4.2) elektrisch anschließt, mit wenigstens einem elektrischen Leiter (7.1, 7.2, 7.3), der mit der Kontaktelektrode (5.1, 5.2, 5.3) verlötet ist und eine elektrische Verbindung zwischen der Kontaktelektrode (5.1, 5.2, 5.3) und dem elektrischen Anschluss (2.1, 2.2, 2.3) herstellt, und mit einem, zumindest teilweise mit mindestens einer Vergussmasse (17) gefüllten Gehäuse (8), das Widerstandselement (4.1, 4.2) und Kontaktelektrode (5.1, 5.2, 5.3) vergossen aufnimmt, wobei der elektrische Leiter (7.1, 7.2, 7.3) durch die Vergussmasse (17) ragt, **dadurch gekennzeichnet, dass** ein Stift, insbesondere ein Löt- oder Einpressstift, den elektrischen Leiter (7.1, 7.2, 7.3) ausbildet, welcher Stift (9.1, 9.2, 9.3) auf die Kontaktelektrode (5.1, 5.2, 5.3) aufgesetzt und mit dieser verlötet ist sowie den elektrischen Anschluss (2.1, 2.2, 2.3) des Leistungswiderstands (1) ausbildet.

2. Leistungswiderstand nach Anspruch 1, **dadurch gekennzeichnet, dass** der Stift (9.1, 9.2, 9.3) an seinem ersten Ende (10.1, 10.2, 10.3) eine ebene Stirnfläche (13) aufweist, welche auf der Kontaktelektrode (5.1, 5.2, 5.3) aufgesetzt und mit dieser verlötet ist.

3. Leistungswiderstand nach Anspruch 1 oder 2, **dadurch gekennzeichnet, dass** der Stift (9.1, 9.2, 9.3) an seinem ersten Ende (10.1, 10.2, 10.3) einen auskragenden Montagekopf (15) aufweist.

4. Leistungswiderstand nach Anspruch 3, **dadurch gekennzeichnet, dass** der Montagekopf (15), insbesondere kreisrund, umlaufend auskragt.

5. Leistungswiderstand nach Anspruch 3, **dadurch gekennzeichnet, dass** der Montagekopf (15) mindestens einen Lötfuß (18.1, 18.2) aufweist.

6. Leistungswiderstand nach Anspruch 3, 4 oder 5, **dadurch gekennzeichnet, dass** der Montagekopf (15) eine ebene Stirnfläche (13) ausbildet.

7. Leistungswiderstand nach einem der Ansprüche 1 bis 6, **dadurch gekennzeichnet, dass** auf dem Trägersubstrat (3) mehrere Kontaktelektroden (5.1, 5.2, 5.3) mit je mindestens einem angelöteten Stift (9.1, 9.2, 9.3) vorgesehen sind, wobei an zwei Kontaktelektroden (5.1, 5.2, 5.3) je ein Widerstandselement (4.1, 4.2) elektrisch anschließt.

8. Leistungswiderstand nach einem der Ansprüche 1 bis 7, **dadurch gekennzeichnet, dass** der als Einpressstift ausgeführte Stift (9.1, 9.2, 9.3) mit seinem Einpresskopf (11.1, 11.2, 11.3) den elektrischen Anschluss (2.1, 2.2, 2.3) ausbildet.

9. Leistungswiderstand nach Anspruch 8, **dadurch gekennzeichnet, dass** der Einpresskopf (11.1, 11.2, 11.3) dem Gehäuse (8) vorsteht.

10. Leistungswiderstand nach einem der Ansprüche 1 bis 9, **dadurch gekennzeichnet, dass** das als Gussform für die Vergussmasse (17) ausgebildete Gehäuse (8) eine erste offene Breitseite (8.3) aufweist.

11. Leistungswiderstand nach einem der Ansprüche 1 bis 10, **dadurch gekennzeichnet, dass** das Trägersubstrat (3) an einer zweiten Breitseite (8.2) des Gehäuses (8) vorgesehen ist.

12. Leistungswiderstand nach einem der Ansprüche 1 bis 11, **dadurch gekennzeichnet, dass** das Widerstandselement (4.1, 4.2) an einem plattenförmigen Trägersubstrat (3) aus einem keramikartigen Material vorgesehen ist.

13. Leistungswiderstand nach einem der Ansprüche 1 bis 12, **dadurch gekennzeichnet, dass** die Vergussmasse (17) mehrschichtig ist, wovon ein erstes Schichtmaterial (17.1) auf Silikonbasis das Widerstandselement (4.1, 4.2) vergießt und der Stift (9.1, 9.2, 9.3) durch ein zweites Schichtmaterial (17.2) auf Epoxidharzbasis ragt.

14. Leistungswiderstand nach Anspruch 13, **dadurch gekennzeichnet, dass** das erste Schichtmaterial (17.1) auf Silikonbasis den Montagekopf (15) des Stifts (9.1, 9.2, 9.3) vergießt.
